# EUROPÄISCHE PATENTSCHRIFT

(11) **EP 0 980 005 B1**
(45) Veröffentlichungstag und Bekanntmachung des Hinweises auf die Patenterteilung: **19.10.2005**
(21) Anmeldenummer: 99115315.6
(22) Anmeldetag: 03.08.1999
(51) Int. Cl.: G01R 31/02, B60R 21/00

(54) **Verfahren zur Funktionsprüfung eines Zündkreises eines Insassenschutzsystems sowie Prüfschaltung**
Method and circuit for functional testing of an ignition circuit from a passenger safety system
Procédé et circuit pour le test fonctionnel d'un circuit d'allumage pour un système de protection de passagers

(30) Priorität: 13.08.1998 DE 19836734
(43) Veröffentlichungstag der Anmeldung: 16.02.2000
(73) Patentinhaber: Conti Temic microelectronic GmbH, 90411 Nürnberg (DE)
(72) Erfinder: Fendt, Günter, 86529 Schrobenhausen (DE)

(56) Entgegenhaltungen:
- EP-A- 0 590 180
- DE-A- 4 032 423
- US-A- 5 136 275

## Beschreibung

Die Erfindung betrifft ein Verfahren zur Funktionsprüfung eines Zündkreises mit einem Zünder eines Insassenschutzsystems sowie eine Prüfschaltung.

Aus dem Gebrauchsmuster DE 92 17 359 U1 ist eine Schaltungsanordnung für die Funktionsprüfung einer mehrstufigen Transistorschaltung zu entnehmen, wie diese in Zündkreisen von Insassenschutzsystemen eingesetzt wird. Die Verwendung für Airbag-Auslöseschaltungen wird dabei explizit erwähnt.

Darüber hinaus sind allgemein eine Vielzahl von Insassenschutzsystemen am Markt erhältlich, bei denen von einer Zentraleinheit oder aber eventuell auch mehreren im Fahrzeug verteilten Endstufen aus jeweils mehrere Zündkreise für Zünder von Insassenschutzeinrichtungen, insbesondere pyrotechnische Zünder von Airbag- oder Gurtstraffer - Gasgeneratoren ausgelöst werden. Die Endstufen sind meist als ASIC integriert und weisen für die zu steuernden Zündkreise die entsprechenden Schaltmittel auf. Über Leitungen werden dann die eigentlichen Zünder angeschlossen. Aus dem Gebrauchsmuster DE 92 17 359 U1 ist eine Prüfschaltung zu entnehmen, die im Zündkreis durch gegenüber den Auslöseströmen sehr geringe Prüfströme den Zündkreis testet, indem die auftretenden Spannungspotentialänderungen mit Schwellwerten verglichen werden. Insbesondere auch unterbrochene Bonddrähte innerhalb des IC-Gehäuses oder defekte Lötstellen können ein Auslösen des Zünders verhindern und müssen erkannt werden.

US-A-513627 offenbart ein Verfahren und eine Vorrichtung zur Überwachung des Erdanschlusses einer Airbag Auslösenschaltung. Die Vorrichtung verfügt über ein Netzwerk von parallelangeordneten Widerständen.

EP-A-0 590 180 beschreibt eine Messanordnung zur Prüfung der Massenanschlüsse einer Schaltung, nämlich einer Steuerschaltung eines Airbagsystemes eines kfz. Die Schaltung hat zwei Anschlüsse zur Erde.

Bei halbleitertechnisch integrierten Schaltungen (ASICs) wird jedoch häufig das Substrat auf Massepotential geschaltet, so daß sich neben einem externen Massepotentialanschluß parallel eine interne Verbindung zum Massepotential auftritt. Aufgrund dieses parallelen internen Massepotentialanschlusses konnten bisher Fehler am externen Massepotentialanschluß nicht erkannt werden, insbesondere nicht bei den geringen Prüfströmen.

Der interne, zweite Massepotentialanschluß bspw. über das Substrat weist jedoch einen höheren Ausgangswiderstand auf und kann insbesondere nicht die zum Zünden erforderlichen hohen Zündströme leiten.

Aufgabe der Erfindung ist es daher, ein Verfahren zur Funktionsprüfung eines Zündkreises eines Insassenschutzsystems sowie eine geeignete Prüfschaltung vorzustellen, mittels dem auch Fehler am externen MassepotentialanschluB erkannt werden.

Diese Aufgabe wird durch das im Anspruch 1 angegebene Verfahren sowie die im Anspruch 3 angegebene Prüfschaltung gelöst. Vorteilhafte Weiterbildungen sind den Unteransprüchen zu entnehmen.

Dazu wird in einem Zündkreis mittels eines den Zünder nicht auslösenden Prüfstroms eine Spannungspotentialänderung hervorgerufen, die mit einem Schwellwert verglichen wird, der überschritten wird, sobald der Prüfstrom über den zweiten Massepotentialanschluß mit dem höheren Ausgangswiderstand anstatt über den ersten Massepotentialanschluß abfließt. Dabei wird der höhere Ausgangswiderstand des zweiten Massepotentialanschlusses ausgenutzt, der gegenüber dem externen Massepotentialanschluß beim Prüfstrom somit einen höheren spannungsabfall aufweist.

Ein Massepotentialanschluß über das Substrat eines ICs weist dabei einen solchen höheren Ausgangswiderstand auf schaltungsinhärent auf, bspw. über entsprechend längere Bahnlängen oder geringe Querschnittsflächen der stromleitenden Bereiche.

Die Erfindung wird nachfolgend anhand von Ausführungsbeispielen und Figuren näher erläutert. Die Figuren zeigen:
- Figur 1: Prüfschaltung zur Erkennung von Fehlern am Massepotentialanschluß eines Zündkreises
- Figur 2: externe Prüfschaltung für mehrere Zündkreise
- Figur 3: integrierte Prüfschaltung für mehrere Zündkreise

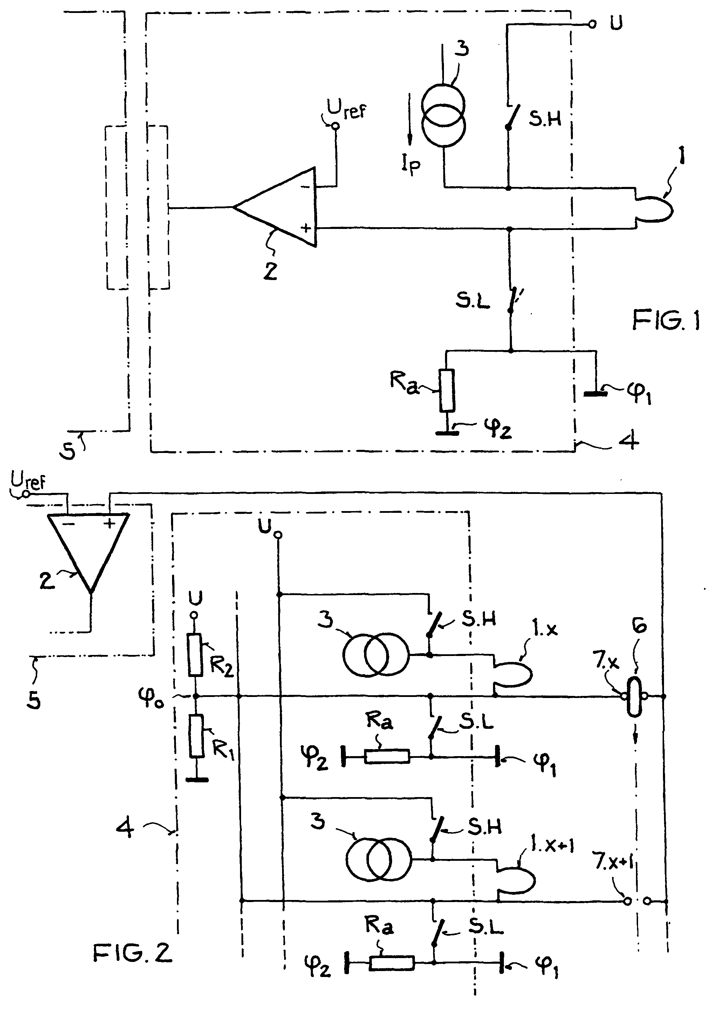

Die Figur 1 zeigt eine Prüfschaltung innerhalb eines integrierten Zündschaltkreises 4, der zumindest einen Zündkreis mit einem Zünder 1 aufweist. Zwischen dem Versorgungspotential U und dem Zünder 1 ist ein erstes Schaltmittel S.H angeordnet welches vorzugsweise ein integriertes Halbleiterschaltelement ist, jedoch auch als ein beschleunigungssensitiver mikromechanischer Sicherheitsschalter ausgestaltet sein kann. Auch eine Reihenschaltung dieser beiden ist denkbar. Zwischen Schaltmittel S.H und dem Zünder 1 wird von der schematisch angedeuteten Prüfstromquelle 3 ein Prüfstrom Ip eingespeist, der nur so groß ist, daß der den Zünder 1 nicht auslöst. Das erste Schaltmittel S.H ist dabei vorzugsweise geöffnet. Auf der entgegengesetzten Seite des Zünders 1 sind hinter dem zweiten Schaltmittel S.L der erste Massepotentialanschluß ϕ1 als externer Massekontakt sowie der zweite Massepotentialanschluß ϕ2 auf Substratpotential liegend dargestellt. Skizzenhaft wird der höhere Ausgangswiderstand als Ra am zweiten, substratseitigen Massepotentialanschluß ϕ2 angedeutet. Der konkrete Schaltungspunkt der Einspeisung des Prüfstroms Ip ist dabei variabel, kann beispielsweise auch nach dem Zünder 1 am Abgriff des Spannungspotentials liegen. Die Prüfstromquelle als auch die Überwachungsschaltung kann sowohl innerhalb des ASICs der Zündendstufe liegen als auch außerhalb, beispielsweise über eine extern anschließbare Prüfschaltung. Als Zündkreis ist der Stromkreis zwischen Versorgungspotential U und den Massepotentialanschlüssen ϕ1/ϕ2 zu verstehen, in dem zumindest lokal masseseitig ein Prüfstrom fließt.

In Figur 1 wird das sich auf den Prüfstrom hin verändernde Spannungspotential zwischen dem Zünder 1 und dem zweiten Schaltmittel S.L abgegriffen und in einem Komparator 2 mit einem Schwellwert U_{ref} verglichen. Der Schwellwert ist dabei derart vorgegeben, daß dieser überschritten wird, sobald der Prüfstrom über den zweiten Massepotentialanschluß ϕ2 mit dem höheren Ausgangswiderstand anstelle über das erste Massepotentialanschluß ϕ1 abfließt. Grundsätzlich kann der Prüfstrom daher auch erst nach dem Zünder 1 oder nach dem zweiten Schaltmittel S.L auf einen der Massepotentialanschlüsse hin eingespeist werden und das Spannungspotential auch an jedem dieser beiden Punkte erfaßt werden. Durchfließt der Prüfstrom jedoch den Zünder 1, so muß er entsprechend so gering dimensioniert werden, daß er den Zünder 1 nicht auslöst. Die in Figur 1 gezeigte Anordnung ermöglicht jedoch mit dem Abgriff zwischen dem Zünder 1 und dem zweiten schaltmittel S.L sowohl eine Funktionsprüfung des zweiten Schaltmittels S.L als auch des Massepotentialanschlusses sowie eine Durchgangsprüfung des Zünders 1 und der diesen verbindenden Leitungen. Kann der Prüfstrom Ip bei geschlossenem zweiten Schaltmittel S.L ungehindert auf den ersten Massepotentialanschluß ϕ1 abfließen, tritt am Komparator 2 ein Spannungspotential deutlich kleiner als der Schwellwert U_{ref} auf, fließt er hingegen beispielsweise aufgrund einer defekten Lötstelle oder eines zerstörten Bonddrahtes nur über den zweiten Massepotentialanschluß ϕ2 und damit über den höheren Ausgangswiderstand Ra, wird dieser deutlich überschritten. Der Komparator 2 erzeugt in Abhängigkeit von diesem Vergleich ein Signal, welches von dem Zündschaltkreis 4 an einen diesen steuernden Mikroprozessor 5 übermittelt wird und der daraufhin beispielsweise den betroffenen Zündkreis als defekt erkennt und im folgenden nicht mehr auslöst und/oder ein Fehlersignal an die Fahrzeuginsassen sendet.

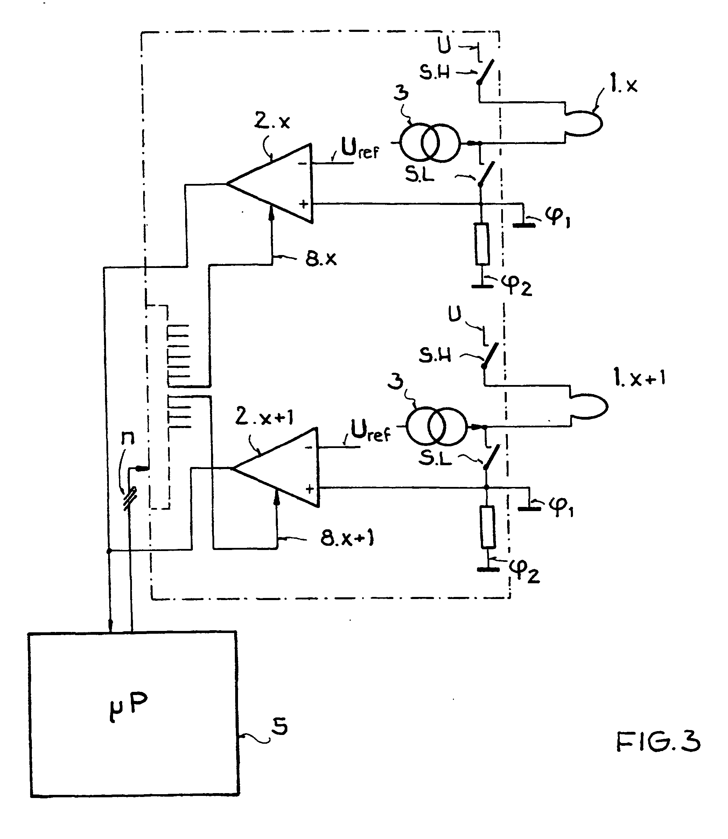

Die Figuren 2 und 3 zeigen Weiterbildungen der Erfindung, bei denen mehrere Zündkreise gleichzeitig oder nacheinander geprüft werden, die in einem Zündschaltkreis 4 integriert sein können. So zeigt Figur 2 beispielhaft zwei Zündkreise mit jeweils einem Zünder 1.x sowie 1.x+1, die in bekannter Weise über die Schaltmittel S.H und S.L mit dem in diesem Fall gemeinsamen Versorgungspotential U sowie die zwei Massepotentialanschlüssen ϕ1 und ϕ2 verbunden sind. Zusätzlich wird zwischen dem Zünder 1 und dem zweiten Schaltmittel S.L ein Ruhepotential ϕ0 über die zwei relativ hochohmigen Widerstände R2 und R1 als Spannungsteiler erzeugt. Diese haben jedoch aufgrund ihrer Hochohmigkeit nahezu keinen Einfluß auf den Prüfstrom. Wird das zweite Schaltmittel S.L eines Zündkreises geschlossen, so stellt sich das Potential nur in Abhängigkeit von dem vom Strom durchflossenen Massepotentialzweig ϕ1 oder ϕ2 ein. Das Spannungspotential wird dabei deutlich absinken ; und zwar auf einen Wert kleiner dem Schwellwert, sofern der Prüfstrom über den ersten Massepotentialanschluß ϕ1 abfließt.

Die Prüfschaltung ist in Figur 2 außerhalb des eigentlichen Zündschaltkreises 4 dargestellt und besteht aus einem Multiplexer 6, der nacheinander die Kontakte ...,7.x, 7.x+1,.... jeweils zwischen Zünder ....1.x,1.x+1,.... und dem jeweiligen zweiten Schaltmittel S.L erfaßt und auf einen gemeinsamen Eingang des Mikroprozessors 5 legt.

Im Mikroprozessor 5 kann entweder, wie dargestellt, ein Komparator 2 zum Vergleich mit dem Schwellwert Uref vorgesehen sein oder aber dies durch entsprechende Signalpegel des Mikroprozessors 5 bereits integriert sein, indem der Mikroprozessor 5 entsprechende Logikpegel aufweist.

In Figur 3 wird ein Ausführungsbeispiel einer Prüfschaltung gezeigt, bei der ebenfalls mehrere Zünder ....1.x,1.x+1,.... überwacht werden, die Prüfschaltung jedoch in den Zündschaltkreis integriert wurde.

So weist die Prüfschaltung für jeden Zünder ....1.x,1.x+1,.... einen eigenen Komparator ....2.x, 2.x+1,.... auf, der jeweils zwischen den zwei Massepotentialanschlüssen und zweitem Schaltmittel S.L das spannungspotential überwacht, wobei der Referenzwert Uref der Komparatoren ....2.x, 2.x+1,.... an diesen gegenüber den Figuren 1 und 2 geänderten Abgriffspunkt angepaßt ist. Die Ausgänge aller Komparatoren ....2.x, 2.x+1,.... können miteinander verbunden und gemeinsam zum Mikroprozessor 5 geleitet werden, wenn die Ausgänge der Komparatoren als Open-Collector-Ausgänge ausgeführt werden und entsprechende Disable-Leitungen ....8.x, 8.x+1,.... an diesen vorgesehen sind, durch welche alle Komparatoren der gerade nicht zu überwachenden Zünder ....1.x, 1.x+1,.... auf einen hochohmigen Zustand gesetzt werden und somit das Signal zum Mikroprozessor 5 nicht beeinflussen. Außerdem ist in Figur 3 eine Prüfstromzufuhr masseseitig der Zünder ....1.x,1.x+1,.... dargestellt.

## Patentansprüche

1. Verfahren zur Funktionsprüfung eines Zündkreises mit einem Zünder (1) eines Insassenschutzsystems, bei dem
a) im Zündkreis der Zünder (1) und steuerbare Schaltmittel (S.H,S.L) zwischen einem Versorgungsspannungspotential (U) und einem ersten Massepotentialanschluß (ϕ1) sowie einem zweiten Massepotentialanschluß (ϕ2) vorgesehen, wobei der zweite Massepotentialanschluß (ϕ2) parallel zum ersten Massepotentialanschluß (ϕ1) geschaltet ist, jedoch einen höheren Ausgangswiderstand (Ra) als der erste Massepotentialanschluß (ϕ1) aufweist,
b) im/am Zündkreis ein Prüfstrom (Ip) erzeugt und die im/am Zündkreis auftretende Spannung mit einem Schwellwert (Uref) verglichen wird, und ein Prüfergebnissignal als defekt setzt, safern die Spannung den Schwellwert erreicht oder überschreitet, **dadurch gekennzeichnet, dass**
c) der Schwellwert (Uref) derart bestimmt wird, daß er überschritten wird, sobald der Prüfstrom (ip) über den zweiten Massepotentialanschluß (ϕ2) mit dem höheren Ausgangswiderstand (Ra) anstatt über, im wesentlichen, den ersten Massepotentialanschluß (ϕ1) abfließt.

2. Verfahren nach Anspruch 1, **dadurch gekennzeichnet, daß** der Prüfstrom (Ip) den Zünder (1) zwar durchfließt, jedoch so gering ist, daß er den Zünder (1) nicht auslöst.

3. Prüfschaltung zur Funktionsprüfung eines Zündkreises mit einem Zünder (1) eines Insassenschutzsystems, **dadurch gekennzeichnet, daß**
a) im Zündkreis der Zünder (1) und steuerbare Schaltmittel (S.H,S.L) zwischen einem Versorgungsspannungspotential (U) und einem ersten Massepotentialanschluß (ϕ1) sowie einem zweiten Massepotentialanschluß (ϕ2) vorgesehen sind, wobei der zweite Massepotentialanschluß (ϕ2) parallel zum ersten Massepotentialanschluß (ϕ1) geschaltet ist, jedoch einen höheren Ausgangswiderstand (Ra) als der erste Massepotentialanschluß (ϕ1) aufweist,
b) eine Prüfstromquelle (3) zur Erzeugung des Prüfstroms (Ip) sowie ein Komparator (2) vorgesehen ist, der die im Zündkreis auftretende Spannung mit einem Schwellwert (Uref) vergleicht und ein Prüfergebnissignal als defekt setzt, sofern die Spannung den Schwellwert erreicht oder überschreitet, **dadurch gekennzeichnet, dass**
c) der Schwellwert (Uref) derart vorgegeben ist, daß er überschritten wird, sobald der Prüfstrom (ip) über den zweiten Massepotentialanschluß (ϕ2) mit dem höheren Ausgangswiderstand (Ra) anstatt, im wesentlichen, über den ersten Massepotentialanschluß (ϕ1) abfließt.

4. Prüfschaltung nach Anspruch 3, **dadurch gekennzeichnet, daß**
a) im Zündkreis zwischen dem Versorgungsspannungspotential (U) und dem Zünder (1) wenigstens ein erstes steuerbares Schaltmittel (S.H) sowie zwischen dem Zünder (1) und dem ersten und zweiten Massepotentialanschluß (ϕ1, ϕ2) wenigstens ein zweites steuerbares Schaltmittel (S.L) sowie eine Steuereinrichtung zum Steuern der Schaltmittel (S.H,S.L) vorgesehen sind und
b) die Prüfstromquelle (3) ebenfalls mittels der Steuereinrichtung steuerbar ist und bei geöffnetem erstem und geschlossenem zweiten Schaltmittel (S.H,S.L) einen den Zünder (1) nicht auslösenden Prüfstrom (Ip) auf der von den Massepotentialanschlüssen abgewandten Seite des Zünders (1) in den Zündkreis einspeist.

5. Prüfschaltung nach Anspruch 3 oder 4, **dadurch gekennzeichnet, daß** der erste Massepotentialanschluß (ϕ1) ein externer Massekontakt ist und der zweite Massepotentialanschluß (ϕ2) auf dem Substratmassepotential liegt.

6. Prüfschaltung nach einem der vorangehenden Ansprüche, **dadurch gekennzeichnet, daß** mehrere Zündkreise eines Insassenschutzsystems mit je einem Zünder von einer Prüfschaltung gemeinsam überwachbar sind.

## Claims

1. Method for testing the performance of an ignition circuit with an ignition device (1) of a passenger protection system in which
a) in the ignition circuit, the ignition device (1) and controllable switching means (S.H, S.L) are provided between a supply voltage (U) and a first connection to earth potential (ϕ₁) and second connection to earth potential (ϕ₂), wherein the second connection to earth potential (ϕ₂) is connected in parallel to the first connection to earth potential (ϕ₁) but comprises a higher output resistance (Rₐ) than the first connection to earth potential (ϕ₁);
b) a testing current (Iₚ) is generated in/at the ignition circuit and the voltage occurring in/at the ignition circuit is compared with a threshold value (U_{ref}) and a test result signal is set "defective" if the voltage reaches or exceeds the threshold value; **characterized in that**
c) the threshold value (U_{ref}) is predetermined such that it is exceeded as soon as the testing current (Iₚ) flows off via the second connection to earth potential (ϕ₂) with the higher output resistance (Rₐ) instead of substantially flowing off via the first connection to earth potential (ϕ₁).

2. Method according to claim 1, **characterized in that** the testing current (Iₚ) flows through the ignition device (1) but is small enough in order not to trip the ignition device (1).

3. Test circuit for testing the performance of an ignition circuit with an ignition device (1) of a passenger protection system, **characterized in that**
a) in the ignition circuit, the ignition device (1) and controllable switching means (S.H, S.L) are provided between a supply voltage (U) and a first connection to earth potential (ϕ₁) and second connection to earth potential (ϕ₂), wherein the second connection to earth potential (ϕ₂) is connected in parallel to the first connection to earth potential (ϕ₁) but comprises a higher output resistance (Rₐ) than the first connection to earth potential (ϕ₁);
b) a testing current source (3) for generating the testing current (Iₚ) and a comparator (2) are provided, said comparator (2) comparing the voltage occurring in the ignition circuit with a threshold value (U_{ref}) and setting a test result signal "defective" if the voltage reaches or exceeds the threshold value; **characterized in that**
c) the threshold value (U_{ref}) is predetermined such that it is exceeded as soon as the testing current (Iₚ) flows off via the second connection to earth potential (ϕ₂) with the higher output resistance (Rₐ) instead of substantially flowing off via the first connection to earth potential (ϕ₁).

4. Test circuit according to claim 3, **characterized in that**
a) in the ignition circuit, there are provided at least a first controllable switching means (S.H) between the supply voltage (U) and the ignition device (1), at least a second controllable switching means (S.L) between the ignition device (1) and the first and second connections to earth potential (ϕ₁, ϕ₂), and a control device for controlling the switching means (S.H, S.L); and
b) the testing current source (3) is controllable by means of the control device, too, and feeds in a testing current (Iₚ) into the ignition circuit on that side of the ignition device (1) that does not face the connections to earth potential, wherein the testing current (Iₚ) does not trip the ignition device (1) and is fed in when the first switching means (S.H) is open and the second switching means (S.L) is closed.

5. Test circuit according to claim 3 or **4, characterized in that** the first connection to earth potential (ϕ₁) is an external earth contact and the second connection to earth potential (ϕ₂) is a connection to the substrate earth potential.

6. Test circuit according to any one of the preceding claims, **characterized in that** several ignition circuits of a passenger protection system with one ignition device each can together be monitored by one test circuit.

## Revendications

1. Procédé de contrôle fonctionnel d'un circuit d'allumage avec un allumeur (1) d'un système de protection d'occupants, dans lequel
a) dans le circuit d'allumage, l'allumeur (1) et des moyens de commutation commandés (S.H, S.L) sont prévus entre un potentiel de tension d'alimentation (U) et un premier raccordement de potentiel de masse (ϕ1) ainsi qu'un deuxième raccordement de potentiel de masse (ϕ2), le deuxième raccordement de potentiel de masse (ϕ2) étant monté en parallèle avec le premier raccordement de potentiel de masse (ϕ1), mais présentant une résistance de sortie plus élevée (Ra) que le premier raccordement de potentiel de masse (ϕ1),
b) dans/sur le circuit d'allumage, un courant de contrôle (Ip) est produit et la tension apparaissant dans/sur le circuit d'allumage est comparée à une valeur de seuil (Uref), et un signal de résultat de contrôle est réglé comme défectueux dans la mesure où la tension atteint la valeur de seuil ou passe sous celle-ci, **caractérisé en ce que**
c) la valeur de seuil (Uref) est définie de façon à être dépassée dès que le courant de contrôle (Ip) s'écoule via le deuxième raccordement de potentiel de masse (ϕ2) avec la résistance de sortie plus élevée (Ra) au lieu de s'écouler essentiellement via le premier raccordement de potentiel de masse (ϕ1).

2. Procédé selon la revendication 1, **caractérisé en ce que** le courant de contrôle (Ip) traverse certes l'allumeur (1) mais est tellement faible qu'il ne déclenche pas l'allumeur (1).

3. Circuit de contrôle pour le contrôle fonctionnel d'un circuit d'allumage avec un allumeur (1) d'un système de protection d'occupants, **caractérisé en ce que**
a) dans le circuit d'allumage, l'allumeur (1) et des moyens de commutation commandés (S.H., S.L) sont prévus entre un potentiel de tension d'alimentation (U) et un premier raccordement de potentiel de masse (ϕ1) ainsi qu'un deuxième raccordement de potentiel de masse (ϕ2), le deuxième raccordement de potentiel de masse (ϕ2) étant monté en parallèle avec le premier raccordement de potentiel de masse (ϕ1), mais présentant une résistance de sortie plus élevée (Ra) que le premier raccordement de potentiel de masse (ϕ1),
b) une source de courant de contrôle (3) destinée à produire le courant de contrôle (Ip) ainsi qu'un comparateur (2) sont prévus, qui comparent la tension apparaissant dans le circuit d'allumage à une valeur de seuil (Uref), et règlent un signal de résultat de contrôle comme défectueux dans la mesure où la tension atteint la valeur de seuil ou passe sous celle-ci, **caractérisé en ce que**
c) la valeur de seuil (Uref) est paramétrée de façon à être dépassée dès que le courant de contrôle (Ip) s'écoule via le deuxième raccordement de potentiel de masse (ϕ2) avec la résistance de sortie plus élevée (Ra) au lieu de s'écouler essentiellement via le premier raccordement de potentiel de masse (ϕ1).

4. Circuit de contrôle selon la revendication 3, **caractérisé en ce que**
a) dans le circuit d'allumage entre le potentiel de tension d'alimentation (U) et l'allumeur (1), il est prévu au moins un premier moyen de commutation commandé (S.H) ainsi que, entre l'allumeur (1) et le premier et le deuxième raccordements de potentiel de masse (ϕ1, ϕ2), il est prévu au moins un deuxième moyen de commutation commandé (S.L) ainsi qu'un équipement de commande pour la commande des moyens de commutation (S.H, S.L) et
b) la source de courant de contrôle (3) est également commandée au moyen de l'équipement de commande et elle introduit dans le circuit d'allumage, quand le premier moyen de commutation (S.H) est ouvert et quand le deuxième moyen de commutation (SL) est fermé, un courant de contrôle (Ip), ne déclenchant pas l'allumeur (1), sur le côté de l'allumeur (1) opposé aux raccordements de potentiel de masse.

5. Circuit de contrôle selon la revendication 3 ou 4, **caractérisé en ce que** le premier raccordement de potentiel de masse (ϕ1) est un contact de masse externe, et le deuxième raccordement de potentiel de masse (ϕ2) est placé sur le potentiel de masse de substrat.

6. Circuit de contrôle selon une des revendications précédentes, **caractérisé en ce que** plusieurs circuits d'allumage d'un système de protection d'occupants avec à chaque fois un allumeur peuvent être surveillés en commun par un circuit de contrôle.
